# EUROPÄISCHE PATENTSCHRIFT

(11) **EP 0 944 453 B1**
(45) Veröffentlichungstag und Bekanntmachung des Hinweises auf die Patenterteilung: **27.03.2002**
(21) Anmeldenummer: 97950182.2
(22) Anmeldetag: 12.11.1997
(51) Int. Cl.: B23K 1/012, B23K 1/018, B23K 3/00, H05K 3/34

(54) **LÖT-/ENTLÖTVORRICHTUNG**
SOLDERING/UNSOLDERING ARRANGEMENT
DISPOSITIF DE SOUDAGE/DESOUDAGE

(30) Priorität: 12.12.1996 DE 29621604 U
(43) Veröffentlichungstag der Anmeldung: 29.09.1999
(73) Patentinhaber: Cooper Tools GmbH, 74354 Besigheim (DE)
(72) Erfinder: STRAUB, Jürgen, D-74196 Neuenstadt (DE)
(74) Vertreter: Grünecker, Kinkeldey, Stockmair & Schwanhäusser Anwaltssozietät
(86) Internationale Anmeldenummer: EP9706317
(87) Internationale Veröffentlichungsnummer: WO9825725

(56) Entgegenhaltungen:
- DE-A- 4 422 341
- DE-U- 9 304 784
- US-A- 4 295 596
- US-A- 4 552 300
- US-A- 4 752 025

## Beschreibung

Die Erfindung betrifft eine Löt-/Entlötvorrichtung, insbesondere für integrierte Schaltkreise mit elektrischen/elektronischen Bauteilen, mit einer ein im wesentlichen glockenförmiges, mit einer unteren Düsenöffnung ausgebildetes Gehäuse aufweisenden Heizdüse, in der eine von einem Heißgas beaufschlagbare Wärmeverteilungsplatte angeordnet ist, wobei zwischen einem Rand der Wärmeverteilungsplatte und dem Gehäuse wenigstens eine Durchtrittsöffnung für in Richtung Düsenöffnung strömendes Heißgas gebildet ist.

Eine solche Löt-/Entlötvorrichtung ist aus der deutschen Gebrauchsmusteranmeldung G 93 04 784 bekannt. Bei der vorbekannten Löt-/Entlötvorrichtung wird eine als Düsenboden ausgebildete Wärmeverteilungsplatte durch einen durch die Heizdüse geführten Heißgasstrom erhitzt. Der Düsenboden ist zu diesem Zweck aus einem gut wärmeleitfähigen Material gebildet. Der Düsenboden kann auf einer Oberfläche eines zu lötenden oder entlötenden Bauteils aufgesetzt werden. Zwischen dem Rand des Düsenboden und dem Gehäuse der Heizdüse ist wenigstens eine Durchtrittsöffnung gebildet, welche einen Durchtritt von Heißgas in Richtung von Anschlußfüßen des zu erwärmenden Bauteils ermöglicht.

Durch das die Durchtrittsöffnung durchströmende Heißgas und durch den durch Beaufschlagung mit Heißgas erwärmten Düsenboden wird auf die entsprechenden Lötstellen ausreichend Wärme zum Löten beziehungsweise Entlöten übertragen.

Bei der bekannten Löt-/Entlötvorrichtung wird die Wärmeverteilungsplatte nur von ihrer dem Bauteil gegenüberliegenden Oberseite her durch Beaufschlagung mit Heißgas erwärmt. Weiterhin tritt der gesamte Heißgasstrom aus der Düsenöffnung und seitlich vom Bauteil aus und strömt entlang einer Leiterplatte, auf der aufgedruckte Schaltkreise und weitere Bauteile angeordnet sind. Dadurch wird einerseits die Wärmeverteilungsplatte insbesondere auf ihrer Oberseite und dem der Durchtrittsöffnung zuweisenden Rand verstärkt erwärmt und andererseits kann das entlang der Leiterplatte abströmende Heißgas zu einer Beschädigung der Schaltkreise und/oder weiteren Bauteile führen.

Der Erfindung liegt daher die Aufgabe zugrunde, die eingangs beschriebene Löt-/Entlötvorrichtung dahingehend zu verbessern, daß eine gleichmäßige Wärmeverteilung zum Löten beziehungsweise Entlöten erreicht wird und gleichzeitig der Ausstoß von Heißgas aus der Heizdüse vermindert wird.

Diese Aufgabe wird bei einer Löt-/Entlötvorrichtung mit den Merkmalen des Oberbegriffs des Anspruchs 1 dadurch gelöst, daß beabstandet zu der Durchtrittsöffnung in der Wärmeverteilungsplatte wenigstens eine Rückführöffnung für durch die Durchtrittsöffnung hindurchgeströmtes Heißgas angeordnet ist.

Dadurch wird die Wärmeverteilungsplatte sowohl von ihrer Oberseite, in ihrem der Durchtrittsöffnung zuweisenden Rand und in Umgebung der Rückführöffnung erwärmt. Dies führt insbesondere zu einer gleichmäßigen Wärmeverteilung in dem Bereich zwischen Rand und Rückführöffnung, wobei dieser Rand den zu lötenden beziehungsweise entlötenden Bereichen des Bauteils vorzugsweise zugeordnet ist. Weiterhin wird zumindest ein Teil des ansonsten aus der Düsenöffnung austretenden Heißgases durch die Rückführöffnung von beispielsweise einer Leiterplatte weggeführt, so daß weniger Heißgas aufgedruckte Schaltkreise oder andere Bauteile beaufschlagt.

Es sei angemerkt, daß die Wärmeverteilungsplatte vorzugsweise ein plattenförmiger Körper mit ebener Oberseite und Unterseite ist. Allerdings kann die Wärmeverteilungsplatte auch nur in den den zu lötenden beziehungsweise entlötenden Bereichen des Bauteils zuweisenden Abschnitten ihrer Unterseite eben sein und kann eine beispielsweise schräg in Richtung Durchtrittsöffnung in Richtung Düsenöffnung nach unten verlaufende Oberseite oder dergleichen aufweisen. Eine plattenförmige Verteilungsplatte ist im Prinzip nur der am einfachsten herstellbare Wärmeverteilungskörper.

Weitere, gattungsfremde Löt-/Entlötvorrichtungen sind bekannt. So offenbart beispielsweise die DE 44 22 341 eine Heizdüse, in der eine Heißgasverteilungspiatte mit Öffnungen unterschiedlicher Durchmesser angeordnet ist. Dadurch soll das Heißgas eine Oberseite eines Bauteils mengenmäßig gesteuert zugeführt werden. Das Heißgas tritt anschließend aus Öffnungen in einem Gehäuse der Heizdüse seitlich aus.

Aus der US-A-4752025 ist weiterhin eine Löt-/Entlötvorrichtung bekannt, bei der in einer Düsenöffnung einer Heizdüse eine die Düsenöffnung teilweise verschließende Abschlußplatte angeordnet ist. Durch diese kann das Heißgas nur benachbart zu Seitenwänden eines Gehäuses der Düse in Richtung Anschlußbeinchen eines Bauteils austreten. Anschließend kann das entlang der Anschlußbeinchen und der Leiterplatte abströmende Heißgas durch eine die Düse teilweise übergreifende Hülse abgesaugt werden.

Die US-A-4295596 offenbart eine weitere Löt-/Entlötvorrichtung, bei der eine Heizdüse ein doppelwandiges Gehäuse mit Innenwand und Außenwand aufweist. In dem von der Innenwand umrandeten Hohlraum ist eine Saugeinrichtung in vertikalter Richtung verstellbar angeordnet. Zwischen Innenwand und Außenwand erfolgt die Zuführung von Heißgas. Dieses strömt aus einer unteren Düsenöffnung benachbarten und im wesentlichen radial nach innen gerichteten Öffnungen aus. Das austretende Heißgas kann durch den von der Innenwand umrandeten Hohlraum abgesaugt werden.

Die US-A-4552300 zeigt eine Löt-/Entlötvorrichtung, bei der im Falle des Entlötens Heißgas über eine mittlere Bohrung in einem Gehäuse der Vorrichtung zurückgeführt wird. Das Aufheizen erfolgt in diesem Fall nur über Zufuhr von Heißgas zu den Lötstellen ohne eine Wärmeverteilungsplatte oder dergleichen. Dabei wird das Heißgas über seitliche, vertikal verlaufende Kanäle der Lötstelle zugeführt und das zugeführte Gas während der Zuführung aufgeheizt. Im Falle des Verlötens erfolgt eine Abgabe des Heißgases nach außen im wesentlichen radial weg von dem aufzulötenden Bauteil.

Um ein einfach aufgebautes und kostengünstiges Gehäuse zu verwenden, kann das Gehäuse eine Deckenwand und eine mit dieser verbundene Umfangswand aufweisen, welche gegenüberliegend zur Deckenwand die Düsenöffnung umrandet.

Um das Heißgas in einfacher Weise bereits in Richtung Düsenöffnung dem Gehäuse zuzuführen, kann in der Deckenwand wenigstens eine Zuführöffnung für das Heißgas ausgebildet sein. Durch diese strömt das Heißgas in Richtung Wärmeverteilungsplatte und von dort oder auch direkt zu der Durchtrittsöffnung und weiter in Richtung Düsenöffnung.

Um die Heizdüse zur Versorgung mit Heißgas in einfacher Weise an einer entsprechenden Heißgasleitung anbringen zu können, kann ein Anschlußstutzen zur Verbindung mit der Heißgasleitung der Löt-/Entlötvorrichtung mit der Zufuhröffnung in Verbindung stehen. Der Anschlußstutzen kann beispielsweise durch eine Schnellkupplung oder dergleichen an der Heißgasleitung angebracht werden.

Bei einem einfachen Ausführungsbeispiel weist der Anschlußstutzen wenigstens ein Anschlußrohrstück und ein zwischen diesem und der Zuführöffnung angeordnetes Verteilungsrohrstück auf. Das Anschlußrohrstück dient zum direkten Ankoppeln an die Heißgasleitung. Das Verteilungsrohrstück kann den zugeführten Heißgasstrom in unterschiedliche Teilströme aufteilen, die beispielsweise in etwa in Richtung zu der oder den Durchtrittsöffnungen gerichtet sind. Günstig ist, wenn im Verteilungsrohrstück ein Rohrboden mit einer Anzahl mit der Zuführöffnung in Verbindung stehenden Verteilungsöffnungen angeordnet ist. Solche Verteilungsöffnungen können beispielsweise einen kreisförmigen Querschnitt haben und in den Ecken eines Vierecks, insbesondere Rechtecks oder Quadrats angeordnet sein.

Um das zu verlötende oder entlötende Bauteil mit der Heizdüse bewegen zu können, kann im Rohrboden ein sich bis zu einer Ansaugöffnung in der Wärmeverteilungsplatte erstreckende Saugeinrichtung gehaltert sein. Durch diese Saugeinrichtung wird das Bauteil beispielsweise zum Positionieren auf einer Leiterplatte und zum anschließenden Verlöten an der oder beabstandet zur Wärmeverteilungsplatte gehalten. Ebenso kann durch die Saugeinrichtung ein entlötetes Bauteil mit der Heizdüse von der integrierten Schaltung oder der Leiterplatte entfernt werden.

Im einfachsten Fall weist die Saugeinrichtung ein sich koaxial im Anschlußstutzen erstreckendes, mit einer Unterdruckquelle verbindbares Saugrohr auf.

Um das Saugrohr in einfacher Weise in der Wärmeverteilungsplatte zu befestigen, kann ein Öffnungsrand einer unteren Öffnung des Saugrohres einen Rand der Ansaugöffnung hintergreifen und beispielsweise mit einem auf der Oberseite der Wärmeverteilungsplatte aufstehenden Teil des Saugrohres diesen Rand formschlüssig halten.

Zum verbesserten Halten des Bauteils und zur verbesserten Abdichtung des Saugrohres, kann in der unteren Öffnung des Saugrohres ein Saugeinsatz einsetzbar sein.

Um das Bauteil einfacher außerhalb des Gehäuses durch die Saugeinrichtung ansaugen zu können oder auf einer Platine ohne sichtbare Behinderung durch das Gehäuse plazieren zu können, können das Saugrohr und/oder eine im Saugrohr angeordnete Ansaugdüse relativ zur Wärmeverteilungsplatte in Längsrichtung verstellbar und/oder verdrehbar gelagert sein. Im Falle der Ansaugdüse ist diese rohrförmig im Saugrohr angeordnet und bezüglich diesem verstellbar und/oder verdrehbar gelagert. Dabei kann die Ansaugdüse aus der unteren Öffnung des Saugrohres herausgefahren werden, wobei sie über die Unterseite der Wärmeverteilungsplatte vorstehen kann.

Zum verbesserten und abgedichteten Ansaugen des Bauteils kann dabei der Saugeinsatz an einem unteren Ende der Ansaugdüse lösbar befestigt sein. Durch die Längsverstellbarkeit und/oder Verdrehbarkeit von Saugrohr und/oder Ansaugdüse kann das Bauteil außerhalb des Gehäuses angesaugt und diesem paßgenau zur teilweisen Aufnahme zugeführt werden.

Zur Anpassung an den Umfang eines Bauteils und um das Bauteil mit möglichst wenig Überstand in Richtung benachbarter Bauteile oder dergleichen zumindest teilweise in der Düsenöffnung aufzunehmen, verläuft die Deckenwand im wesentlichen horizontal und weist einen viereckigen Umfang auf, wobei die Umfangswand aus vier Seitenwänden gebildet ist, die sich im wesentlichen senkrecht zur Deckenwand erstrecken. Der viereckige Umfang entspricht dabei dem Umfang des Bauteils. Das Gehäuse kann als austauschbares und an das jeweilige Bauteil anpaßbares Auswechselteil ausgebildet sein.

Bei Bauteilen mit seitlich abstehenden Anschlußbeinchen ist von Vorteil, wenn zwischen unteren Enden der Seitenwände und beispielsweise der Leiterplatte eine gewisse Menge Heißgas austritt und die sich möglicherweise bis über die Seitenwände hinauserstreckenden Anschlußbeinchen zum Verlöten oder Entlöten ausreichend erwärmt. Soll allerdings ein Bauteil mit zwischen diesem und der Leiterplatte angeordneten Lötpunkten, eine sogenannte Ball-Grid-Anordnung, ver- oder entlötet werden, so ist eine Umlenkung des Heißgasstroms in Richtung Bauteil, das heißt in Richtung Lötpunkte, von Vorteil. Dabei kann das Gehäuse das Bauteil mit seinen Lötpunkten vollständig umgeben und auf der Leiterplatte aufsetzen. Um in diesem Zusammenhang ein Austreten von Heißgas aus dem Gehäuse zu verhindern, ist es vorteilhaft, wenn ein Dichtrand durch untere Enden der Seitenwände gebildet ist. Dieser setzt auf der Leiterplatte außerhalb des Bauteils auf und dient einerseits zusammen mit der Leiterplatte zur Umlenkung des Heißgasstroms in Richtung Lötpunkte und verhindert andererseits weitestgehend ein Austreten des Heißgases aus dem Gehäuse. Dabei wird der Heißgasstrom über die Rückführöffnung oder -öffnungen von der Leiterplatte und dem Bauteil weggeführt.

In der Regel wird ein Bauteil entlang seines gesamten Umfangs über seitlich abstehende Anschlußbeinchen oder entsprechende Lötpunkte verlötet. In diesem Zusammenhang erweist es sich als günstig, wenn zwischen jeder Seitenwand und dem Rand der Wärmeverteilungsplatte jeweils eine Durchtrittsöffnung für Heißgas ausgebildet ist. Auf diese Weise werden alle Anschlußbeinchen oder Lötpunkte gleichzeitig erwärmt.

Im einfachsten Fall ist die Durchtrittsöffnung als Durchtrittsschlitz ausgebildet. Dieser weist eine Länge auf, die zumindest dem Bereich des Bauteils entspricht, an dem entsprechende Anschlußbeine oder Lötpunkt vorhanden sind.

Im einfachsten Fall erstreckt sich die Durchtrittsöffnung im wesentlichen über die gesamte Länge der Seitenwand.

Um den Zusammenbau der Heizdüse zu vereinfachen und gleichzeitig die Durchtrittsöffnungen beziehungsweise Durchtrittsschlitze auf einen Bereich entlang der Seitenwände zu beschränken, kann die Wärmeverteilerplatte in ihren Ecken Ausrichtvorsprünge aufweisen. Diese weisen in Richtung entsprechender Verbindungsecken von jeweils zwei Seitenwänden und können dort die Durchtrittsöffnung oder den Durchtrittsschlitz begrenzen.

Die Rückführöffnung oder - öffnungen können entsprechend zu den Durchtrittsöffnungen, das heißt beispielsweise als Durchtrittsschlitz, ausgebildet sein. Im einfachsten Fall ist eine Anordnung von Rückführöffnungen in jeder Ecke der Wärmeverteilerplatte in dieser ausreichend. Einfachste Ausführungsbeispiele für Rückführöffnungen können einen im wesentlichen kreisförmigen Umfang aufweisen.

Die Rückführöffnungen können als Bohrungen in der Wärmeverteilerplatte ausgebildet sein. Um durch die Wärmeverteilungsplatte rückgeführtes Heißgas nicht einfach an der Oberseite der Wärmeverteilungsplatte austreten zu lassen, können die Rückführöffnungen durch in der Wärmeverteilungsplatte befestigte Rohrstükke gebildet sein. Diese können sowohl nach unten als auch nach oben über die Wärmeverteilungsplatte vorstehen. Nach oben über die Oberseite der Wärmeverteilungsplatte vorstehende Enden der Rohrstücke können so gekrümmt sein, daß sie im wesentlichen in Richtung des auf der Oberseite abströmenden Heißgases gerichtet sind. Dadurch wird das rückzuführende Heißgas durch das den Durchtrittsöffnungen zuströmende Heißgas im wesentlichen nach dem Prinzip einer Wasserstrahlpumpe abgeführt.

Die Rohrstücke können insbesondere auf der der Düsenöffnung zuweisenden Unterseite der Wärmeverteilungsplatte flächenbündig in dieser enden. Dadurch kann die Wärmeverteilungsplatte beispielsweise auch auf einer Oberseite des Bauteils aufgelegt werden.

Um insbesondere bei abdichtender Anlage des Gehäuses auf der Leiterplatte Heißgas über die Rückführöffnungen aus dem Gehäuse abzuführen, können die Rohrstücke in einer dem Anschlußstutzen zuweisenden Oberseite der Deckenwand münden. Auf diese Weise wird das rückgeführte Heißgas aus dem Gehäuse entfernt. Es können auch Rohrstücke mit unterschiedlichen Funktionen, siehe oberhalb der Wärmeverteilungsplatte und in der Oberseite der Deckenwand mündende Rohrstücke, miteinander kombiniert werden.

Um das Heißgas in diesem Fall nicht beispielsweise in Richtung eines Benutzers der Löt-/Entlötvorrichtung zu leiten, kann ein solches Rohrstück über eine Rückleitung mit einer Heißgasquelle verbunden sein, zu der das Heißgas zur erneuten Aufwärmung in einem geschlossenen Kreislauf zurückgeführt wird.

Um in diesem Fall die Rückführung zur Erzielung einer bestimmten Löt- oder Entlöttemperatur oder zur Verwendung einer bestimmten Heißgasmenge zu steuern, können die Rohrstücke mit einer Zwangsrückführungseinrichtung für das Heißgas verbunden sein. Eine solche Zwangsrückführungseinrichtung kann beispielsweise eine Pumpe sein, über die gesteuert Heißgas durch die Rückführungsöffnungen abpumpbar ist. Dadurch läßt sich beispielsweise die Temperatur am Bauteil oder auch die Strömungsgeschwindigkeit des Heißgasstroms steuern oder regeln.

Wenn die Wärmeverteilungsplatte unverstellbar relativ zum Gehäuse in diesem angebracht ist, ist ein Abstand zwischen Unterseite der Wärmeverteilungsplatte und Dichtrand der Seitenwände von Vorteil, der zumindest so groß wie eine Bauhöhe des zu lötenden oder entlötenden Bauteils ist. Bei einem insbesondere senkrecht zum Bauteil im Gehäuse verstellbar gelagerter Wärmeverteilungsplatten kann der Abstand entsprechend eingestellt werden.

Damit die Wärmeverteilungsplatte eine an sich bekannte Infrarot-Heizquelle auf der dem Bauteil gegenüberliegenden Seite des Schaltkreises oder der Platine besonders wirkungsvoll ersetzen kann, kann die Wärmeverteilungsplatte zumindest auf ihrer Unterseite ein Material mit hohem Infrarot-Emissionsgrad aufweisen. Ein solches Material ist beispielsweise geschwärzter Stahl, wobei die Wärmeverteilungsplatte an sich auch aus Stahl hergestellt sein kann.

Ebenso kann die Unterseite der Wärmeverteilungsplatte eine Beschichtung aus einem Material mit hohem Infrarot-Emissionsgrad aufweisen, das beispielsweise unterschiedlich zum Material der Wärmeverteilungsplatte ist. Ein solches Material ist beispielsweise Emaille und insbesondere weißes Emaille.

Im folgenden wird ein vorteilhaftes Ausführungsbeispiel der Erfindung anhand der in der Zeichnung beigefügten Figuren näher erläutert und beschrieben.

Es zeigen:
- Figur 1: eine Unteransicht des Ausführungsbeispiels einer Heizdüse einer erfindungsgemäßen Löt-/Entlötvorrichtung;
- Figur 2: einen Schnitt entlang der Linie II-II nach Figur 1;
- Figur 3: einen Schnitt entlang der Linie III-III aus Figur 1;
- Figur 4: einen Schnitt entlang der Linie IV-IV aus Figur 1, und
- Figur 5: einen Schnitt analog zu Figur 3 entlang der Linie III-III aus Figur 1 bei einem weiteren Ausführungsbeispiel einer erfindungsgemäßen Löt-/Entlötvorrichtung.

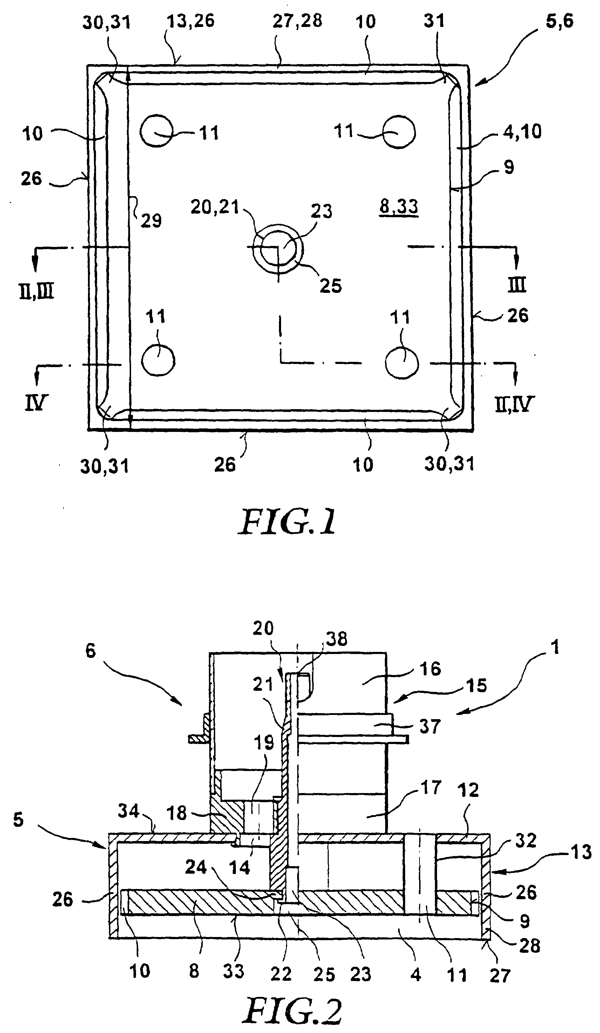

In Figur 1 ist eine Draufsicht von unten auf eine erfindungsgemäße Löt-/Entlötvorrichtung dargestellt, wobei insbesondere eine Unterseite 33 einer Wärmeverteilungsplatte 8 sichtbar ist. Diese weist einen in etwa quadratischen Umriß mit in ihren Ekken 30 nach außen weisenden Ausrichtvorsprüngen 31 auf. In der Wärmeverteilungsplatte 8 sind beabstandet zu den Ecken 30 vier Rückführöffnungen 11 ausgebildet, die die Wärmeverteilungsplatte 8 durchsetzen.

Ein Gehäuse 5 einer Heizdüse 6 der Löt-/Entlötvorrichtung weist ebenfalls einen in etwa quadratischen Umriß auf, der von vier eine Umfangswand 13 bildenden Seitenwänden 26 gebildet ist. Die Seitenwände 26 umgrenzen eine Düsenöffnung 4, in die die Wärmeverteilungsplatte 8 eingesetzt ist. Durch einen Rand 9 der Wärmeverteilungsplatte 8 und die Seitenwände 26 wird die Düsenöffnung 4 bis auf sich im wesentlichen über die gesamte Länge 29 der Seitenwände 26 erstreckende schlitzförmige Durchtrittsöffnungen 10 eingeengt.

Die schlitzförmigen Durchtrittsöffnungen 10 erstrecken sich bis jeweils zu den Ausrichtvorsprüngen 31 und verlaufend parallel zum Rand 9 oder zu den Seitenwänden 26.

Mittig in der Wärmeverteilungsplatte 8 ist eine Ansaugöffnung 25 angeordnet. In dieser mündet eine untere Öffnung 23 eines Saugrohres 21 einer Saugeinrichtung 20. Diese wird im folgenden näher beschrieben.

Figur 2 zeigt einen Schnitt entlang der Linie II-II aus Figur 1. Gleiche Teile sind in Figur 2 wie auch in den folgenden Figuren durch gleiche Bezugszeichen gekennzeichnet.

Von der erfindungsgemäßen Löt-/Entlötvorrichtung 1 ist insbesondere die Heizdüse 6 mit Gehäuse 5 und Anschlußstutzen 15 dargestellt. Das Gehäuse 5 ist in etwa glockenförmig ausgebildet. Es weist eine horizontale Deckenwand 12 auf, von der entlang ihres Umfangs als Umfangswand 13 vier Seitenwände 26 senkrecht abstehen, siehe auch Figur 1.

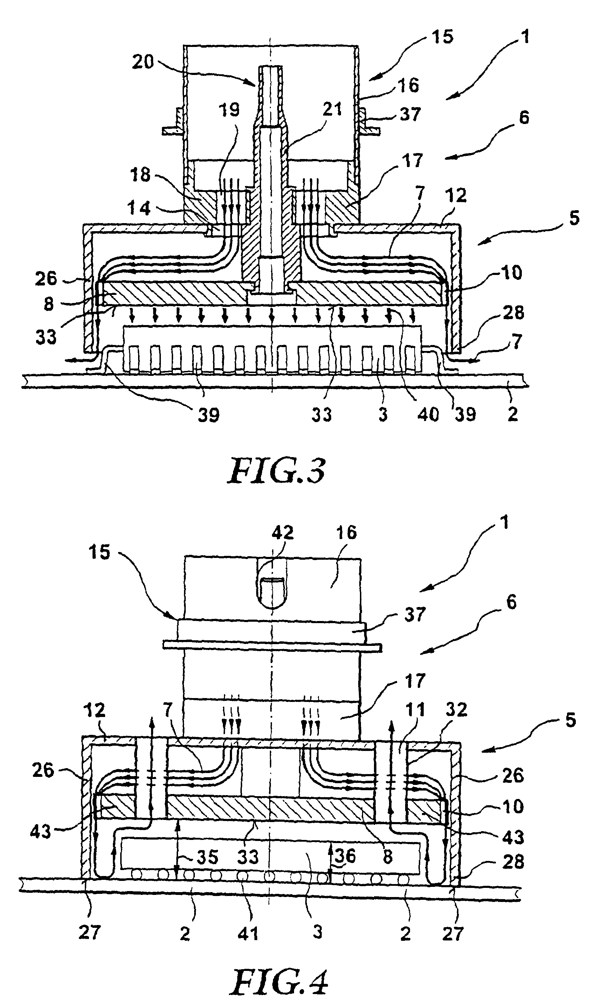

Die Seitenwände 26 begrenzen mit ihren unteren Enden 28 die Düsenöffnung 4, aus der über den Anschlußstutzen 15 zugeführtes Heißgas ausströmen kann. Durch die unteren Enden 28 wird weiterhin ein Dichtrand 27 gebildet, wie insbesondere im Zusammenhang mit Figur 4 im folgenden dargestellt ist.

Innerhalb des Gehäuses 5 ist die Wärmeverteilungsplatte 8 angeordnet. Zwischen derem Rand 9 und den Seitenwänden 26 sind die Durchtrittsöffnungen 10 gebildet.

Mittig in der Wärmeverteilungsplatte 8 ist die Ansaugöffnung 25 ausgebildet. In dieser mündet das Saugrohr 21 der Saugeinrichtung 20. Die untere Öffnung 23 des Saugrohres 21 weist einen radial nach außen abstehenden Öffnungsrand 22 auf, der einen entsprechenden radial nach innen in die Ansaugöffnung 25 vorstehenden Öffnungsrand 24 hintergreift.

Das Saugrohr 21 erstreckt sich senkrecht zur Wärmeverteilungsplatte 8 und durchsetzt eine in der Deckenwand 12 gebildete Zuführöffnung 14 konzentrisch. Das Saugrohr 21 erstreckt sich bis in etwa zum oberen Ende des Anschlußstutzens 15. Dieser dient zur Befestigung der Heizdüse 6 an der übrigen, nicht dargestellten Löt-/Entlötvorrichtung 1. Das Saugrohr 21 endet mit einer Eintrittsöffnung 38, an der eine nicht dargestellte Unterdruckquelle anschließbar ist.

In der Zuführöffnung 14 ist weiterhin ein unteres Ende des Anschlußstutzen 15 eingesetzt und dort befestigt. Der Anschlußstutzen 15 umfaßt ein Anschlußrohrstück 16 und ein Verteilungsrohrstück 17, welche beide im wesentlichen gleichen Außendurchmesser aufweisen. Das Anschlußrohrstück 16 ist von oben auf das Verteilungsrohrstück 17 aufgesteckt. Weiterhin ist auf der Außenseite des Anschlußrohrstück 16 ein Halteflansch 37 befestigt.

Das Verteilungsrohrstück 17 weist einen auf einer Oberseite 34 der Deckenwand 12 aufliegenden Rohrboden 18 auf. In diesem sind eine Anzahl von Verteilungsöffnungen 19 zur Zufuhr und Verteilung von Heißgas in das Gehäuse 5 angeordnet. Zusätzlich zur Befestigung in der Wärmeverteilungsplatte 8 ist das Saugrohr 21 ebenfalls im Rohrboden 18 des Verteilungsrohrstück 17 befestigt.

Bei dem Schnitt nach Figur 2 ist eine Rückführöffnung 11 in der Wärmeverteilungsplatte 8 sichtbar. Diese ist durch ein Rohrstück 32 gebildet, das in einer der Deckenwand 12 gegenüberliegenden Unterseite 33 der Wärmeverteilungsplatte 8 flächenbündig mündet. Das Rohrstück 32 erstreckt sich bis zu einer der Wärmeverteilungsplatte 8 gegenüberliegenden Oberseite 34 der Deckenwand 12. Dort mündet das Rohrstück 32 ebenfalls flächenbündig. Das Rohrstück 32 ist beabstandet zum Rand 9 der Wärmeverteilungsplatte und damit beabstandet zur Durchtrittsöffnung 10 angeordnet. Umriß und Verteilung der Rückführöffnungen 11 sind in Figur 1 beispielhaft dargestellt.

In den folgenden Figuren 3 und 4 sind zwei unterschiedliche Anwendungen der Löt-/Entlötvorrichtung 1 dargestellt. Bei Figur 3 dient die Löt-/Entlötvorrichtung mit ihrer Heizdüse 6 zum Löten oder Entlöten eines Bauteils 3 mit seitlich von diesem abstehenden Anschlußbeinchen 39. Das Bauteil 3 ist dabei auf einer Leiterplatine oder integrierten Schaltung 2 aufgesetzt. Die Darstellung nach Figur 3 entspricht einem Schnitt entlang der Linie III-III nach Figur 1.

Über den Anschlußstutzen 15 ist Heißgas 7, wie durch die mit Pfeilen versehenen, durchgehenden Linien dargestellt ist, den Anschlußbeinchen 39 zuführbar. Das Heißgas 7 strömt durch die Verteilungsöffnungen 19 im Rohrboden 18 und entlang der Wärmeverteilungsplatte 8 in Richtung zu den Durchtrittsöffnungen 10. Dort wird das Heißgas 7 entlang der Seitenwände 26 in Richtung Leiterplatine 2 umgelenkt und trifft benachbart zu den unteren Enden 28 der Seitenwände 26 auf die Anschlußbeinchen 39. Durch die Anordnung der Durchtrittsöffnungen 10 entsprechend zu Figur 1 erfolgt eine gleichmäßige und gleichzeitige Zuleitung von Heißgas zu allen seitlich von dem Bauteil 3 abstehenden Anschlußbeinchen.

Über die Rückführöffnungen 11 kann ein Teil des Heißgases 7 durch die Wärmeverteilungsplatte 8 rückgeführt und aus dem Gehäuse 5, siehe Figur 2, nach oben durch die Deckenwand 12 abgegeben werden.

Durch die Führung des Heißgases erfolgt eine zweifache Erwärmung des Bauteils 3 und insbesondere der Anschlußbeinchen 39. Zum einen trifft das Heißgas direkt auf die Anschlußbeinchen 39 auf. Zum anderen wird die Wärmeverteilungsplatte 8 durch das zwischen dieser und der Deckenwand 12, durch die Durchtrittsöffnungen 10 und durch die Rückführöffnungen 11 strömende Heißgas 7 erwärmt. Dadurch dient die Wärmeverteilungsplatte 8 zur zusätzlichen Erwärmung des Bauteils 3 und damit auch der Anschlußbeinchen 39, wie durch die durch Pfeile dargestellte Wärmestrahlung 40 dargestellt ist. Auf diese Weise kann beispielsweise auf eine zusätzliche Erwärmung von Bauteil 3 und Anschlußbeinchen 39 von der dem Bauteil 3 gegenüberliegenden Seite der Leiterplatine 2, wie beispielsweise durch einen Infrarotstrahler, verzichtet werden.

In Figur 4 ist ein Schnitt durch die Heizdüse 6 entlang der Linie IV-IV aus Figur 1 dargestellt. In diesem Fall dient die Löt-/Entlötvorrichtung 1 zum Löten oder Entlöten eines Bauteils 3 mit auf dessen Unterseite angeordneten Lötpunkten 41. Eine solche Anordnung der Lötpunkte wird allgemein als Ball-Grid-Array (BGA) bezeichnet. Die Lötpunkte 41 sind zwischen Bauteil 3 und Leiterplatine 2 angeordnet. Bei einem solchen BGA wird das Gehäuse 5 auf der Leiterplatine 2 aufgesetzt, so daß durch den durch die unteren Enden 28 der Seitenwände 26 gebildeten Dichtrand 27 eine Abdichtung zwischen Gehäuse 5 und Leiterplatine 2 hergestellt ist. Das Heißgas 7 strömt wie beim Ausführungsbeispiel nach Figur 3 durch die Verteilungsöffnung 19, zwischen Wärmeverteilungsplatte 8 und Deckenwand 12 und durch die Durchtrittsöffnungen 10 in Richtung Leiterplatine 2 nach unten. Aufgrund der Abdichtung zwischen Seitenwänden 26 und Leiterplatine 2 wird das Heißgas 7 seitlich in Richtung Bauteil 3 umgelenkt und von dort in Richtung Wärmeverteilungsplatte 8 und über die Rückführöffnungen 11 nach oben in Richtung Anschlußstutzen 15 abgeführt. Durch die Führung des Heißgases 7 sind insbesondere Randbereiche 43 der Wärmeverteilungsplatte 8 stärker erwärmt, die die Erwärmung der Lötpunkte 41 durch den in Richtung Bauteil 3 umgelenkten Heißgasstrom unterstützen. In diesem Zusammenhang sein angemerkt, daß die Lötpunkte 41 im allgemeinen in Randbereichen des Bauteils 3 nahe dessen Außenumfang angeordnet sind.

Zusätzlich wirkt die gesamte Wärmeverteilungsplatte 8, wie auch in Figur 3, als Wärmestrahler, wobei die entsprechende Wärmestrahlung 40 in Figur 4 zur Vereinfachung nicht dargestellt ist.

Ein Abstand 35 zwischen Unterseite 33 der Wärmeverteilungsplatte 8 und der Leiterplatine 2 ist in der Regel größer als eine Bauhöhe 36 des Bauteils 3, so daß auch bei durch das Bauteil 3 überdeckten Rückführöffnungen 11 eine Rückführung von Heißgas möglich ist. Bei dem Anwendungsbeispiel nach Figur 3 kann die Wärmeverteilungsplatte 8 auch mit ihrer Unterseite 33 auf dem Bauteil 3 aufsitzen.

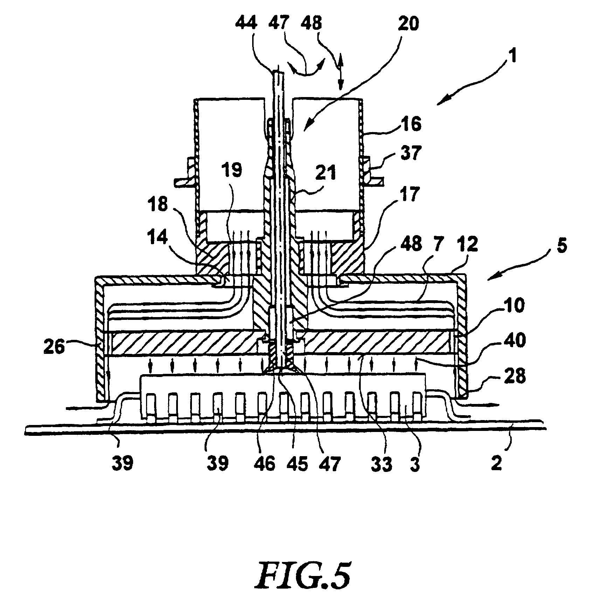

Zur Vereinfachung ist ein Saugeinsatz, der in der unteren Öffnung 23 des Saugrohres 21, siehe beispielsweise Figuren 2 oder 3, eingesetzt ist, nicht dargestellt. Ein solcher Saugeinsatz, siehe Figur 5, ist an sich bekannt und erstreckt sich über die Unterseite 33 der Wärmeverteilungsplatte 8 in Richtung Bauteil 3. Durch den Saugeinsatz wird eine abdichtende Ankopplung des Saugrohres 21 an das Bauteil 3 gewährleistet.

Weiterhin sind in den Figuren beispielsweise eine Heißgasquelle zur Erzeugung und Zuführung von Heißgas zum Anschlußstutzen 15 und ein Zwangsrückführungseinrichtung für an der Oberseite 34 der Deckenwand 12 abgegebenes Heißgas nicht dargestellt. Durch eine solche Zwangsrückführungseinrichtung kann Heißgas durch die Rückführungsöffnungen 11 aus dem Gehäuse 5 gesteuert entnommen werden und beispielsweise auch zur Heißgasquelle zurückgeführt werden. Auf diese Weise kann insbesondere bei dem Ausführungsbeispiel nach Figur 4 im wesentlichen ein geschlossener Kreislauf für Heißgas gebildet werden. Weiterhin ist in Figur 4 am oberen Ende des Anschlußrohrstücks 16 ein Ausrichtschlitz 42 ausgebildet, durch den ein ausgerichtetes Anordnen und Befestigen der Heizdüse 6 an der übrigen, nicht dargestellten Löt-/Entlötvorrichtung 1 möglich ist.

Figur 5 zeigt Schnitt analog zu Figur 3 entlang der Linie III-III aus Figur 1, siehe auch Figur 3, mit einem weiteren Ausführungsbeispiel der erfindungsgemäßen Löt-/Entlötvorrichtung 1. Gleiche Zeichen kennzeichnen wiederum gleiche Bauteile und werden nur noch teilweise erwähnt.

Das Ausführungsbeispiel nach Figur 5 unterscheidet sich von dem nach Figur 3 darin, daß in dem Saugrohr 21 der Saugeinrichtung 20 eine rohrförmige Ansaugdüse 44 sowohl in Längsrichtung 48 verstellbar als auch in Richtungen 47 verdrehbar innerhalb des Saugrohres 21 gelagert ist. Die Ansaugdüse 44 steht mit ihrem unteren Ende 47 aus der unteren Öffnung 23, siehe Figur 2, hervor. An diesem unteren Ende 47 ist ein Saugeinsatz 46 lösbar befestigt. Dieser umrandet eine untere Öffnung 45 der Ansaugdüse 44 mit einem schräg nach unten in Richtung Oberseite des Bauteils 3 verlaufenden Dichtungsrand.

Die Ansaugdüse 44 ist zumindest bis in die komplementär zum Saugeinsatz 46 ausgebildete Aufnahme 48 zurückziehbar, welche sich an die untere Öffnung des Saugrohres 21 in Richtung Anschlußrohrstück 16 anschließt.

Eine analoge Ansaugdüse mit Saugeinsatz ist ebenfalls bei Bauteilen 3 mit einem Ball-Grid-Array, siehe Figur 4, einsetzbar.

## Patentansprüche

1. Löt-/Entlötvorrichtung (1), insbesondere für integrierte Schaltkreise (2) mit elektrischen/elektronischen Bauteilen (3), mit einer ein im wesentlichen glockenförmiges, mit einer unteren Düsenöffnung (4) ausgebildetes Gehäuse (5) aufweisenden Heizdüse (6), in der eine von einem Heißgas (7) beaufschlagbare Wäremverteilungsplatte (8) angeordnet ist, wobei zwischen einem Rand (9) der Wärmeverteilungsplatte (8) und dem Gehäuse (5) wenigstens eine Durchtrittsöffnung (10) für in Richtung Düsenöffnung (4) strömendes Heißgas gebildet ist,
**dadurch gekennzeichnet,**
**daß** beabstandet zu der Durchtrittsöffnung (10) in der Wärmeverteilungsplatte (8) wenigstens eine Rückführöffnung (11) für durch die Durchtrittsöffnung (10) hindurchgeströmtes Heißgas (7) angeordnet ist.

2. Löt-/Entlötvorrichtung nach Anspruch 1,
**dadurch gekennzeichnet,**
**daß** das Gehäuse (5) eine Deckenwand (12) und eine mit dieser verbundene Umfangswand (13) aufweist, welche gegenüberliegend zur Deckenwand die Düsenöffnung (4) umrandet.

3. Löt-/Entlötvorrichtung nach Anspruch 2,
**dadurch gekennzeichnet,**
**daß** in der Deckenwand (12) wenigstens eine Zuführöffnung (14) für Heißgas (7) ausgebildet ist.

4. Löt-/Entlötvorrichtung nach Anspruch 3,
**dadurch gekennzeichnet,**
**daß** ein Anschlußstutzen (15) zur Verbindung mit einer Heißgasleitung der Löt-/Entlötvorrichtung mit der Zuführöffnung (14) in Verbindung steht.

5. Löt-/Entlötvorrichtung nach Anspruch 4,
**dadurch gekennzeichnet,**
**daß** der Anschlußstutzen (15) wenigstens ein Anschlußrohrstück (16) und ein zwischen diesem und der Zuführöffnung (14) angeordnetes Verteilungsrohrstück (17) aufweist.

6. Löt-/Entlötvorrichtung nach Anspruch 5,
**dadurch gekennzeichnet,**
**daß** im Verteilungsrohrstück (17) ein Rohrboden (18) mit einer Anzahl von mit der Zuführöffnung (14) in Verbindung stehenden Verteilungsöffnungen (19) angeordnet ist.

7. Löt-/Entlötvorrichtung nach wenigstens einem der vorangehenden Ansprüche,
**dadurch gekennzeichnet,**
**daß** im Rohrboden (8) ein sich bis zu einer Ansaugöffnung (25) in der Wärmeverteilungsplatte (8) erstreckende Saugeinrichtung (20) gehaltert ist.

8. Löt-/Entlötvorrichtung nach Anspruch 7,
**dadurch gekennzeichnet,**
**daß** die Saugeinrichtung (20) ein sich koaxial im Anschlußstutzen (15) erstreckendes, mit einer Unterdruckquelle verbindbares Saugrohr (21) aufweist.

9. Löt-/Entlötvorrichtung nach Anspruch 8,
**dadurch gekennzeichnet,**
**daß** ein Öffnungsrand (22) einer unteren Öffnung (23) des Saugrohres (21) einen Rand (24) der Ansaugöffnung (25) hintergreift.

10. Löt-/Entlötvorrichtung nach Anspruch 9,
**dadurch gekennzeichnet,**
**daß** in der unteren Öffnung (23) ein Saugeinsatz einsetzbar ist.

11. Löt-/Entlötvorrichtung nach wenigstens einem der Ansprüche 8 bis 10,
**dadurch gekennzeichnet,**
**daß** das Saugrohr (21) und/oder eine im Saugrohr angeordnete Ansaugdüse (44) relativ zur Wärmeverteilungsplatte (8) in Längsrichtung verstellbar und/oder verdrehbar gelagert sind.

12. Löt-/Entlötvorrichtung nach den vorangehenden Ansprüchen 10 und 11,
**dadurch gekennzeichnet,**
**daß** der Saugeinsatz (46) an einem unteren Ende (47) der Ansaugdüse (44) lösbar befestigt ist.

13. Löt-/Entlötvorrichtung nach Anspruch 2,
**dadurch gekennzeichnet,**
**daß** die Deckenwand (12) im wesentlichen horizontal verläuft und einen viereckigen Umfang aufweist, wobei die Umfangswand (13) aus vier Seitenwänden (26) gebildet ist, die sich im wesentlichen senkrecht zur Deckenwand (12) erstrecken.

14. Löt-/Entlötvorrichtung nach Anspruch 13,
**dadurch gekennzeichnet,**
**daß** ein Dichtrand (27) durch untere Enden (28) der Seitenwände (26) gebildet ist.

15. Löt-/Entlötvorrichtung nach wenigstens einem der Ansprüche 13 bis 14,
**dadurch gekennzeichnet,**
**daß** zwischen jeder Seitenwand (26) und dem Rand (9) der Wärmeverteilungsplatte (8) jeweils eine Durchtrittsöffnung (10) ausgebildet ist.

16. Löt-/Entlötvorrichtung nach Anspruch 15,
**dadurch gekennzeichnet,**
**daß** die Durchtrittsöffnung (10) als Durchtrittsschlitz ausgebildet ist.

17. Löt-/Entlötvorrichtung nach wenigstens einem der Ansprüche 15 bis 16,
**dadurch gekennzeichnet,**
**daß** die Durchtrittsöffnung (10) sich im wesentlichen über die gesamte Länge (29) der Seitenwand (26) erstreckt.

18. Löt-/Entlötvorrichtung nach wenigstens einem der vorangehenden Ansprüche,
**dadurch gekennzeichnet,**
**daß** die Wärmeverteilungsplatte (8) in ihren Ecken (30) Ausrichtvorsprünge (31) aufweist.

19. Löt-/Entlötvorrichtung nach wenigstens einem der vorangehenden Ansprüche,
**dadurch gekennzeichnet,**
**daß** Rückführöffnungen (11) in jeder Ecke (30) der Wärmeverteilungsplatte (28) in dieser angeordnet sind.

20. Löt-/Entlötvorrichtung nach wenigstens einem der vorangehenden Ansprüche,
**dadurch gekennzeichnet,**
**daß** die Rückführöffnung (11) einen im wesentlichen kreisförmigen Umfang aufweist.

21. Löt-/Entlötvorrichtung nach wenigstens einem der vorangehenden Ansprüche,
**dadurch gekennzeichnet,**
**daß** die Rückführöffnung (11) durch ein in der Wärmeverteilungsplatte (8) befestigtes Rohrstück (32) gebildet ist.

22. Löt-/Entlötvorrichtung nach Anspruch 21,
**dadurch gekennzeichnet,**
**daß** das Rohrstück (32) im wesentlichen flächenbündig in einer der Düsenöffnungen (4) zuweisenden Unterseite (33) der Wärmeverteilungsplatte (8) endet.

23. Löt-/Entlötvorrichtung nach Anspruch 21,
**dadurch gekennzeichnet,**
**daß** das Rohrstück (32) in einer dem Anschlußstutzen (15) zuweisenden Oberseite (34) der Deckenwand (12) mündet.

24. Löt-/Entlötvorrichtung nach wenigstens einem der Ansprüche 21 bis 23,
**dadurch gekennzeichnet,**
**daß** das Rohrstück (32) über eine Rückleitung mit einer Heißgasquelle verbunden ist.

25. Löt-/Entlötvorrichtung nach wenigstens einem der Ansprüche 21 bis 24,
**dadurch gekennzeichnet,**
**daß** das Rohrstück (32) mit einer Zwangsrückführungseinrichtung für das Heißgas (7) verbunden ist.

26. Löt-/Entlötvorrichtung nach wenigstens einem der vorangehenden Ansprüche,
**dadurch gekennzeichnet,**
**daß** ein Abstand (35) zwischen Unterseite (33) der Wärmeverteilungsplatte (8) und Dichtrand (27) größer oder gleich einer Bauhöhe (36) eines zu verlötenden oder zu entlötenden Bauteils (3) ist.

27. Löt-/Entlötvorrichtung nach wenigstens einem der vorangehenden Ansprüche,
**dadurch gekennzeichnet,**
**daß** die wärmeverteilungsplatte (8) zumindest auf ihrer Unterseite (33) ein Material mit hohem Infrarot-Emissionsgrad aufweist.

28. Löt-/Entlötvorrichtung nach wenigstens einem der vorangehenden Ansprüche,
**dadurch gekennzeichnet,**
**daß** die Unterseite (33) eine Beschichtung aus einem Material mit hohem Infrarot-Emissionsgrad aufweist.

## Claims

1. A soldering/desoldering device (1), in particular for integrated circuits (2) with electric/electronic components (3), comprising a heater nozzle (6) with a substantially bell-shaped housing (5) formed with a lower nozzle opening (4), said heater nozzle (6) having disposed therein a heat distribution plate (8) which can be acted upon by a hot gas (7), and an edge (9) of the heat distribution plate (8) and the housing (5) having formed thereinbetween at least one passage opening (10) for hot gas flowing towards the nozzle opening (4),
**characterized in**
**that** at least one return opening (11) for hot gas (7) flowing through the passage opening (10) is disposed in spaced-apart relationship with the passage opening (10) in the heat distribution plate (8).

2. A soldering/desoldering device according to claim 1,
**characterized in**
**that** the housing (5) comprises a cover wall (12) and a circumferential wall (13) connected to said cover wall, which opposite to the cover wall surrounds the nozzle opening (4).

3. The soldering/desoldering device according to claim 2,
**characterized in**
**that** at least one supply opening (14) for hot gas (7) is formed in the cover wall (12).

4. The soldering/desoldering device according to claim 3,
**characterized in**
**that** a pipe union (15) for connection to a hot gas line of the soldering/desoldering device communicates with the supply opening (14).

5. The soldering/desoldering device according to claim 4,
**characterized in**
**that** the pipe union (15) comprises at least one connection pipe member (16) and a distribution pipe member (17) arranged between said connection pipe member and the supply opening (14).

6. The soldering/desoldering device according to claim 5,
**characterized in**
a pipe bottom (18) is arranged in the distribution pipe member (17) with a plurality of distribution openings (19) communicating with the supply opening (14).

7. The soldering/desoldering device according to at least one of the preceding claims,
**characterized in**
**that** a suction means (20) which extends up to a suction opening (25) in the heat distribution plate (8) is held in the pipe bottom (8).

8. The soldering/desoldering device according to claim 7,
**characterized in**
**that** the suction means (20) comprises a suction pipe (21) which coaxially extends in the pipe union (15) and is connectable to a vacuum source.

9. The soldering/desoldering device according to claim 8,
**characterized in**
**that** an opening edge (22) of a lower opening (23) of the suction pipe (21) grips behind an edge (24) of the suction opening (25).

10. The soldering/desoldering device according to claim 9,
**characterized in**
**that** a suction insert is insertable in the lower opening (23).

11. A soidering/desoldering device according to at least one of claims 8 to 10,
**characterized in**
**that** the suction pipe (21) and/or a suction nozzle (44) which is arranged in the suction pipe is/are supported to be longitudinally adjustable and/or rotatable relative to the heat distribution plate (8).

12. The soldering/desoldering device according to the preceding claims 10 and 11,
**characterized in**
**that** the suction insert (46) is detachably secured to a lower end (47) of the suction nozzle (44).

13. The soldering/desoldering device according to claim 2,
**characterized in**
**that** the cover wall (12) extends in a substantially horizontal direction and has a four-cornered circumference, the circumferential wall (13) being formed of four side walls (26) which extend in a direction substantially perpendicular to the cover wall (12).

14. The soldering/desoldering device according to claim 13,
**characterized in**
**that** a sealing edge (27) is formed by lower ends (28) of the side walls (26).

15. The soldering/desoldering device according to at least one of claims 13 to 14,
**characterized in**
**that** a respective passage opening (10) is formed between each side wall (26) and the edge (9) of the heat distribution plate (8).

16. The soidering/desoidering device according to claim 15,
**characterized in**
**that** the passage opening (10) is formed as a passage slot.

17. The soidering/desoldering device according to at least one of claims 15 to 16,
**characterized in**
**that** the passage opening (10) extends substantially over the entire length (29) of the side wall (26).

18. The soldering/desoldering device according to at least one of the preceding claims,
**characterized in**
**that** the heat distribution plate (8) comprises alignment projections (31) in the comers (30) thereof.

19. The soldering/desoldering device according to at least one of the preceding claims,
**characterized in**
**that** retum openings (11) are arranged in each comer (30) of the heat distribution plate (28) in said plate.

20. The soldering/desoldering device according to at least one of the preceding claims,
**characterized in**
**that** the return opening (11) has a substantially circular circumference.

21. The soldering/desoldering device according to at least one of the preceding claims,
**characterized in**
**that** the return opening (11) is formed by a pipe member (32) secured within the heat distribution plate (8).

22. The soldering/desoldering device according to claim 21,
**characterized in**
**that** the pipe member (32) terminates in substantially planar flush configuration in a bottom side (33) of the heat distribution plate (8) which faces the nozzle openings (4).

23. The soldering/desoldering device according to claim 21,
**characterized in**
**that** the pipe member (32) terminates in an upper side (34) of the cover wall (12) which faces the pipe union (15).

24. The soldering/desoldering device according to at least one of claims 21 to 23,
**characterized in**
**that** the pipe member (32) is connected via a return line to a source of hot gas.

25. The soldering/desoldering device according to at least one claims 21 to 24,
**characterized in**
**that** the pipe member (32) is connected to a forced return means for hot gas (7).

26. The soldering/desoldering device according to at least one of the preceding
claims,
**characterized in**
**that** a distance (35) between the bottom side (33) of the heat distribution plate (8) and a sealing edge (27) is greater than or equal to a constructional height (26) of a component (3) which is to be soldered or desoldered.

27. The soldering/desoldering device according to at least one of the preceding claims,
**characterized in**
**that** the heat distribution plate (8) is provided at least on its bottom side (33) with a material of high infrared emissivity.

28. The soldering/desoldering device according to at least one of the preceding claims,
**characterized in**
**that** the bottom side (33) has a coating made of a material of high infrared emissivity.

## Revendications

1. Dispositif de brasage et de débrasage (1), en particulier pour des circuits intégrés (2) munis de composants électriques et électroniques (3), comprenant une buse de chauffage (6), qui est munie d'un boîtier (5), conçu sensiblement en forme de cloche avec une ouverture inférieure (4) de la buse, et dans laquelle est montée une plaque de répartition de la chaleur (8) susceptible d'être sollicitée par un gaz chaud (7), au moins un orifice de passage (10) étant réalisé, entre un bord (9) de la plaque de répartition de la chaleur (8) et le boîtier (5), pour le gaz chaud affluant en direction de l'ouverture de la buse (4), **caractérisé en ce qu'**au moins un orifice de reflux (11) pour le gaz chaud (7) affluant à travers l'orifice de passage (10) est réalisé dans la plaque de répartition de la chaleur (8) à une distance donnée de l'orifice de passage (10).

2. Dispositif de brasage et de débrasage selon la revendication 1, **caractérisé en ce que** le boîtier (5) comporte une paroi de couverture (12) et une paroi périphérique (13) assemblée avec celle-ci, laquelle, sur le côté opposé à la paroi de couverture, entoure l'ouverture de la buse (4).

3. Dispositif de brasage et de débrasage selon la revendication 2, **caractérisé en ce qu'**au moins un orifice d'admission (14) pour le gaz chaud (7) est réalisé dans la paroi de couverture (12).

4. Dispositif de brasage et de débrasage selon la revendication 3, **caractérisé en ce qu'**un ajutage (15), qui est destiné à être assemblé avec une conduite de gaz chaud du dispositif de brasage et de débrasage, communique avec l'orifice d'admission (14).

5. Dispositif de brasage et de débrasage selon la revendication 4, **caractérisé en ce que** l'ajutage (15) comporte au moins un embout de tube de raccordement (16) et un embout de tube de distribution (17) disposé entre celui-ci et l'orifice d'admission (14).

6. Dispositif de brasage et de débrasage selon la revendication 5, **caractérisé en ce que** l'embout de tube de distribution (17) comporte un fond (18) muni d'une pluralité d'orifices de distribution (19) qui communiquent avec l'orifice d'admission (14).

7. Dispositif de brasage et de débrasage selon au moins l'une des revendications précédentes, **caractérisé en ce qu'**un système d'aspiration (20), qui s'étend jusqu'à un orifice d'aspiration (25) réalisé dans la plaque de répartition de la chaleur (8), est maintenu dans le fond du tube (8).

8. Dispositif de brasage et de débrasage selon la revendication 7, **caractérisé en ce que** le système d'aspiration (20) comporte un tube d'aspiration (21), qui s'étend dans le sens coaxial dans l'ajutage (15) et qui peut être raccordé à une source de dépression.

9. Dispositif de brasage et de débrasage selon la revendication 8, **caractérisé en ce qu'**un bord (22) d'une ouverture inférieure (23) du tube d'aspiration (21) peut entrer en prise par l'arrière avec un bord (24) de l'orifice d'aspiration (25).

10. Dispositif de brasage et de débrasage selon la revendication 9, **caractérisé en ce qu'**un insert d'aspiration peut être inséré dans l'ouverture inférieure (23).

11. Dispositif de brasage et de débrasage selon au moins l'une des revendications 8 à 10, **caractérisé en ce que** le tube d'aspiration (21) et/ou une buse d'aspiration (44), disposée dans le tube d'aspiration, peuvent être logés de manière à pouvoir coulisser dans le sens longitudinal et/ou de manière à pouvoir tourner par rapport à la plaque de répartition de la chaleur (8).

12. Dispositif de brasage et de débrasage selon les revendications précédentes 10 et 11, **caractérisé en ce que** l'insert d'aspiration (46) peut être fixé de manière amovible sur une extrémité inférieure (47) de la buse d'aspiration (44).

13. Dispositif de brasage et de débrasage selon la revendication 2, **caractérisé en ce que** la paroi de couverture (12) s'étend sensiblement horizontalement et présente un contour rectangulaire, la paroi périphérique (13) étant formée par quatre parois latérales (26), qui sont sensiblement perpendiculaires à la paroi de couverture (12).

14. Dispositif de brasage et de débrasage selon la revendication 13, **caractérisé en ce qu'**un bord étanche (27) est formé par les extrémités inférieures (28) des parois latérales (26).

15. Dispositif de brasage et de débrasage selon au moins l'une des revendications 13 à 14, **caractérisé en ce que** respectivement un orifice de passage (10) est formé entre chaque paroi latérale (26) et le bord de la plaque de répartition de la chaleur (8).

16. Dispositif de brasage et de débrasage selon la revendication 15, **caractérisé en ce que** l'orifice de passage (10) est conçu sous forme de fente de passage.

17. Dispositif de brasage et de débrasage selon au moins l'une des revendications 15 à 16, **caractérisé en ce que** l'orifice de passage (10) s'étend sensiblement sur toute la longueur (29) de la paroi latérale (26).

18. Dispositif de brasage et de débrasage selon au moins l'une des revendications précédentes, **caractérisé en ce que** la plaque de répartition de la chaleur (8) comporte des saillies de centrage (31), réalisées dans les coins (30) de celle-ci.

19. Dispositif de brasage et de débrasage selon au moins l'une des revendications précédentes, **caractérisé en ce que** des orifices de reflux (11) sont réalisés dans la plaque de répartition de la chaleur (28) dans chaque coin (30) de celle-ci.

20. Dispositif de brasage et de débrasage selon au moins l'une des revendications précédentes, **caractérisé en ce que** l'orifice de reflux (11) présente un contour sensiblement circulaire.

21. Dispositif de brasage et de débrasage selon au moins l'une des revendications précédentes, **caractérisé en ce que** l'orifice de reflux (11) est formé par un embout tubulaire (32) fixé dans la plaque de répartition de la chaleur (8).

22. Dispositif de brasage et de débrasage selon la revendication 21, **caractérisé en ce que** l'embout tubulaire (32) finit sensiblement en affleurement avec la surface d'une face inférieure (33), orientée vers les ouvertures de la buse (4), de la plaque de répartition de la chaleur (8).

23. Dispositif de brasage et de débrasage selon la revendication 21, **caractérisé en ce que** l'embout tubulaire (32) débouche dans une face supérieure (34), orientée vers l'ajutage (15), de la paroi de couverture (12).

24. Dispositif de brasage et de débrasage selon au moins l'une des revendications 21 à 23, **caractérisé en ce que** l'embout tubulaire (32) est assemblé avec une source de gaz chaud par l'intermédiaire d'une conduite de reflux.

25. Dispositif de brasage et de débrasage selon au moins l'une des revendications 21 à 24, **caractérisé en ce que** l'embout tubulaire (32) est assemblé avec un dispositif de guidage forcé du gaz chaud (7).

26. Dispositif de brasage et de débrasage selon au moins l'une des revendications précédentes, **caractérisé en ce qu'**une distance (35) entre la face inférieure (33) de la plaque de répartition de la chaleur (8) et le bord d'étanchéité (27) est supérieure ou égale à une hauteur (36) d'un composant (3) à braser ou débraser.

27. Dispositif de brasage et de débrasage selon au moins l'une des revendications précédentes, **caractérisé en ce que** la plaque de répartition de la chaleur (8) est réalisée au moins sur sa face inférieure (33) dans un matériau avec un degré de rayonnement infrarouge élevé.

28. Dispositif de brasage et de débrasage selon au moins l'une des revendications précédentes, **caractérisé en ce que** la face inférieure (33) est munie d'un revêtement réalisé dans un matériau avec un degré de rayonnement infrarouge élevé.
